Europäisches Patentamt

(19) European Patent Office

Office européen des brevets

(11) Numéro de publication : **0 282 370 B1**

(12) **FASCICULE DE BREVET EUROPEEN**

(45) Date de publication du fascicule du brevet :
24.07.91 Bulletin 91/30

(51) Int. Cl.⁵ : **H03K 19/177**

(21) Numéro de dépôt : 88400303.9

(22) Date de dépôt : 10.02.88

(54) **Réseau logique dynamique.**

(30) Priorité : 12.02.87 FR 8701741

(43) Date de publication de la demande :
14.09.88 Bulletin 88/37

(45) Mention de la délivrance du brevet :
24.07.91 Bulletin 91/30

(84) Etats contractants désignés :
BE CH DE FR GB IT LI LU NL SE

(56) Documents cités :
DE-A- 3 635 761
US-A- 4 381 460
PATENT ABSTRACTS OF JAPAN, vol. 10, no.
283 (E-440)[2339], 26 septembre 1986; & JP-
A-61 101 124

(56) Documents cités :
IBM TECHNICAL DISCLOSURE BULLETIN,
vol. 24, no. 2, juillet 1981, pages 1165-1166,
New York, US; W.R. KRAFT et al.:
"Programmed logic array"
IEEE JOURNAL OF SOLID-STATE CIRCUITS,
vol. SC-11, no. 3, juin 1976, pages 370-374,
New York, US; E. HEBENSTREIT et al.:
"High-speed programmable logic arrays in
ESFI SOS technology"

(73) Titulaire : BULL S.A.
121, Avenue de Malakoff
F-75116 Paris (FR)

(72) Inventeur : Anceau, François
4, rue Emmanuel Mounier
F-78379 Plaisir (FR)

(74) Mandataire : Fournier, Michel Robert Marie et
al
Bull S.A. Industrial Property Department P.C. :
HQ 8M006 BP 193.16 121 avenue de Malakoff
F-75764 Paris Cédex 16 (FR)

**Description**

La présente invention concerne les réseaux logiques destinés à délivrer au moins un signal de sortie représentant une fonction logique d'une pluralité de variables logiques d'entrée.

Les réseaux logiques peuvent être conçus dès la fabrication en vue de réaliser directement des fonctions logiques déterminées. Ils peuvent être aussi fabriqués sous forme pré-caractérisée pour être programmable par l'utilisateur.

La présente invention peut s'appliquer à ces deux types de réseaux logiques programmés ou programmables.

Une fonction logique quelconque peut toujours être représentée comme la somme logique de produits logiques de certaines des variables d'entrée ou de leur complément. La fonction logique est alors sous une forme disjonctive et chaque produit de la somme est appelée minterme.

Une fonction logique peut également être représentée sous une forme conjonctive, duale de la forme disjonctive. La fonction logique apparaît alors comme le produit logique de sommes logiques de certaines des variables d'entrée ou de leur complément. Ces sommes logiques sont appelées maxtermes.

Ainsi les réseaux logiques programmés ou programmables sont constitués de deux matrices, chaque matrice étant composée par une pluralité de portes logiques d'un type donné.

Les variables logiques d'entrée sont appliquées directement ou par l'intermédiaire d'un inverseur aux entrées des portes logiques de la première matrice.

Les signaux de sortie de cette matrice représentent les valeurs logiques des monômes (mintermes ou maxtermes) intervenant pour définir les fonctions logiques.

Certains des signaux de sortie de la première matrice sont ensuite appliqués aux entrées des portes logiques de la deuxième matrice et les signaux présents sur les sorties de cette deuxième matrice représentent les valeurs logiques que prennent les différentes fonctions logiques pour des valeurs données des variables logiques d'entrée.

Ainsi, par exemple les réseaux logiques peuvent être constitués par une première matrice comprenant une pluralité de portes ET à plusieurs entrées et d'une seconde matrice de portes logiques OU à plusieurs entrées reliées à certaines des sorties des portes logiques ET de la première matrice. On utilise ainsi la forme disjonctive.

Si l'on utilise la forme conjonctive, la première matrice sera constituée de portes OU tandis que la seconde matrice sera formée de portes ET.

Une autre possibilité préférable aux précédentes consiste à réaliser un réseau logique au moyen de deux matrices composées de portes logiques NI ou de deux matrices composées de portes logiques NON-ET (NAND).

Dans le cas le plus simple, les portes logiques utilisées pour réaliser ces matrices sont du type statique, ce qui permet un fonctionnement très rapide du réseau logique. Cependant les portes logiques statiques ne permettent pas une très grande densité d'intégration et impliquent une forte consommation statique.

Pour éviter ces inconvénients, il est préférable d'utiliser des portes logiques dynamiques travaillant en deux phases : une phase de précharge et une phase fonctionnelle. C'est le cas en particulier des matrices de portes logiques dites "CMOS" qui utilisent des transistors à effet de champs à canal n ou p (NMOS ou PMOS). On peut ainsi réaliser des réseaux de portes NI à très haute densité d'intégration. En logique positive, ces portes sont réalisées à l'aide de transistors du type NMOS ayant leur source à la masse et leur drain relié à la ligne de sortie de la porte. En inversant les signaux d'entrée, ces portes deviennent des portes ET.

Il est possible également de réaliser des réseaux de portes NON-ET (NAND) en utilisant des transistors du type PMOS. Cependant les transistors de ce dernier type sont plus volumineux que les transistors de type NMOS, ce qui ne permet pas une intégration aussi dense.

Toutefois l'inconvénient des portes logiques dynamiques est de nécessiter une phase de précharge de leur ligne de sortie précédant une phase fonctionnelle. Il en résulte que les réseaux logiques en technologie CMOS nécessitent aussi plusieurs phases de fonctionnement.

Une solution peut consister à précharger simultanément les lignes de sortie des deux matrices pendant une première phase (phase de précharge), cette opération nécessitant l'isolement des lignes de sortie de la première matrice des lignes d'entrée de la seconde matrice.

Après cette phase de précharge, la première matrice est activée par la validation de ses signaux d'entrée. Puis la seconde matrice est rendue active en supprimant l'isolation entre les deux matrices. La phase de précharge est donc suivie de deux phases fonctionnelles. Les deux phases fonctionnelles sont nécessaires du fait que les tensions de sortie de la première matrice doivent être stabilisées avant de pouvoir être appliquées aux entrées de la seconde matrice.

Le but de l'invention est de réaliser un réseau logique dynamique pouvant fonctionner en deux phases seulement et ainsi améliorer sa rapidité.

Ce problème a déjà été évoqué et une solution y a été apportée dans la demande de brevet japonaise. JP-A-61101124. Ce document concerne un circuit intégré comportant un réseau OU et un réseau ET préchargés. Le réseau ET est évalué sous le contrôle d'un premier signal d'horloge ($\phi$1) pour arrêter la pré-

charge et appliquer un signal de sortie à l'entrée capacitive d'une porte NON-OU (NOR). Pendant ce temps, des transistors de précharge du réseau OU sont activés. Le réseau OU est évalué sous le contrôle d'un deuxième signal d'horloge ($\phi$2). Par la répétition de ces opérations, on effectue des précharges/lectures complémentaires du réseau ET et du réseau OU.

L'invention propose une autre solution permettant un fonctionnement plus sûr en particulier lorsque les phases de précharges et d'évaluation sont rapprochées.

Plus précisément, l'invention se rapporte à un réseau logique constitué d'une première matrice de portes logiques dont les signaux de sortie sont transmis aux entrées d'une seconde matrice constituée d'une ou plusieurs portes logiques, chaque porte logique desdites matrices étant des portes NI dynamiques réalisées au moyen de transistors à effet de champs à canal n, une phase de précharge servant à charger à une tension déterminée (Vdd) les lignes de sortie desdites portes logiques par des moyens de précharge rendus actifs par un signal de commande de précharge, ledit réseau comprenant des moyens de mémorisation dont les entrées sont reliées aux sorties de la première matrice par l'intermédiaire de premiers moyens d'isolement commandés, les sorties desdits moyens de mémorisation étant reliés aux entrées de la seconde matrice par l'intermédiaire de seconds moyens d'isolement commandés, lesdits premiers moyens d'isolement étant commandés pour autoriser le transfert des signaux issus de la première matrice vers lesdits moyens de mémorisation pendant la phase de précharge de la seconde matrice, lesdits seconds moyens d'isolement étant commandés pour autoriser le transfert des données contenues dans lesdits moyens de mémorisation vers la seconde matrice pendant la phase de précharge de la première matrice, ledit réseau étant caractérisé en ce que lesdits moyens de précharge desdites portes NI comprennent des moyens pour appliquer sur leurs entrées une tension nulle, lesdits moyens étant activés pendant la phase de précharge desdites portes logiques, à partir d'un signal d'horloge directement dérivé de celui servant à la précharge.

L'invention propose également un mode de réalisation particulier qui sera exposé en détails dans la description qui va suivre.

La figure 1 représente un schéma d'ensemble d'un réseau logique selon l'invention.

La figure 2 représente un mode de réalisation du réseau logique selon l'invention.

La figure 3 représente les chronogrammes des principaux signaux intervenant dans le circuit de la figure 2.

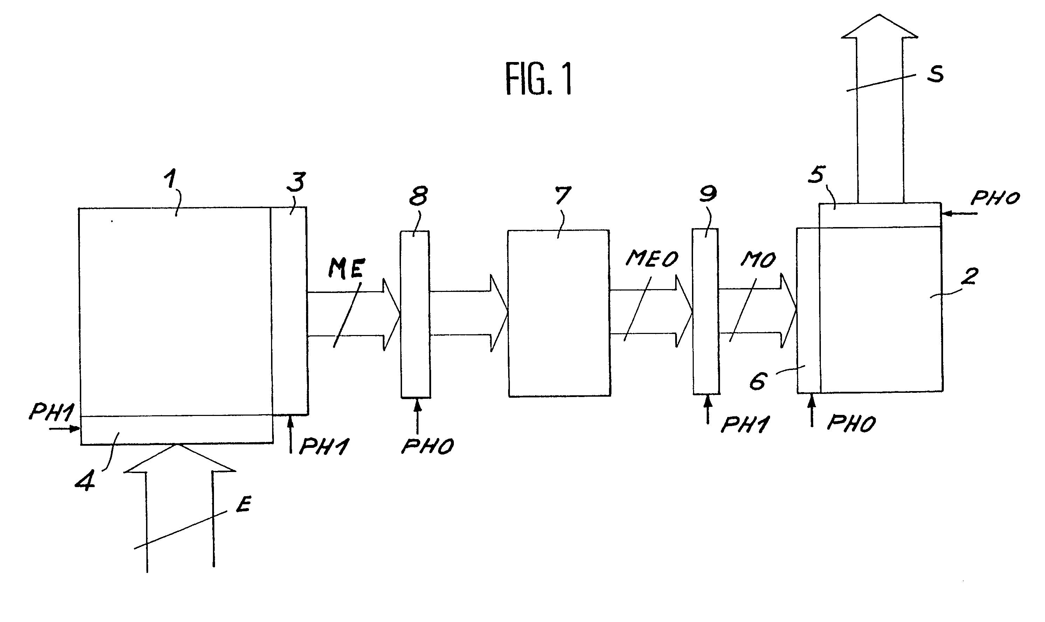

La figure 1 représente sous sa forme la plus générale un réseau logique de type dynamique selon l'invention. De façon classique, il comprend une première matrice 1 recevant des variables logiques d'entrée E et une deuxième matrice 2 délivrant en sortie un ou plusieurs signaux S représentant une ou plusieurs fonctions logiques des variables d'entrée E.

Ces variables d'entrée E sont des signaux représentant des variables logiques indépendantes ainsi que leur complément.

Les deux matrices 1, 2 sont constituées par une pluralité de portes logiques, ces portes logiques pouvant être des portes ET, OU, NI, NON-ET. Le type de portes logiques utilisées dans chacune des matrices pourra évidemment être choisi en tenant compte des fonctions logiques que l'on désire réaliser. Par ailleurs, ces portes logiques sont de type dynamique et doivent travailler en deux phases : une première phase de précharge de leurs lignes de sortie, définie respectivement par les signaux PH1 et PH0 pour la première et la deuxième matrice et une deuxième phase fonctionnelle définie respectivement par PH0 et PH1 pour la première et la deuxième matrice.

Quelle que soit la solution envisagée pour réaliser les deux matrices 1, 2 il conviendra de prévoir des moyens de précharge de ces matrices. Les moyens de précharge de la première matrice sont constitués par des circuits de précharge 3 mettant en communication les lignes de sortie ME de cette matrice avec une source de tension d'alimentation. Par ailleurs, les moyens de précharge comprennent un circuit 4 pour forcer les lignes d'entrée de la première matrice à une tension déterminée. Ces tensions de forçage des entrées seront évidemment choisies en fonction de la tension de précharge des sorties et du type de porte logique utilisé dans la première matrice. Par exemple, si on utilise des portes NI réalisées à l'aide de transistors NMOS, la ligne de sortie de ces portes est préchargée à une tension positive, par exemple 5 volts et il conviendra alors que toutes les lignes d'entrée de la matrice soient forcées à la valeur 0 volt. Ces deux circuits 3, 4 des moyens de précharge sont rendus actifs par le signal de phase PH1 ou un signal fonction de ce dernier.

La situation est analogue dans le cas de portes ET qui sont réalisées à partir des portes NI après inversion des signaux d'entrée.

Si on utilise des portes NON-ET réalisées à l'aide de transistors PMOS ayant leur source reliée à une tension positive, les drains étant reliés entre eux pour constituer la sortie de la porte, la sortie sera préchargée à 0 volt et les entrées seront forcées à une tension positive.

De même, la deuxième matrice 2 est associée à des moyens de précharge 5, 6, ces moyens de précharge étant constitués par un circuit de précharge 5 des lignes de sortie de cette matrice et du circuit 6 permettant de forcer les lignes d'entrée à une tension convenable. Ces deux circuits 5, 6 sont activés par le signal PH0 ou un signal fonction de PH0.

Les lignes de sortie ME de la première matrice sont reliées à des moyens de mémorisation 7 par l'intermédiaire de moyens d'isolement 8 commandés par le signal PH0. Les moyens d'isolement 8 fonctionnent comme des interrupteurs qui se ferment en présence du signal PH0. Un interrupteur est interposé entre chaque ligne de sortie de la première matrice et la ligne d'entrée correspondante des moyens de mémorisation 7. Ces moyens de mémorisation 7 sont constitués par autant de cellules de mémorisation que la matrice 1 a de sorties.

Les lignes de sortie MEO des moyens de mémorisation 7 sont reliées à des seconds moyens d'isolement 9. Ces seconds moyens d'isolement ont une fonction analogue à celle des premiers moyens d'isolement 8. Ils sont commandés par le signal PH1, et se ferment lorsque ce signal est présent.

Les lignes de sortie MO des seconds moyens d'isolement 9 sont reliés aux lignes d'entrée de la seconde matrice 2 par l'intermédiaire du circuit de forçage 6.

Nous allons maintenant décrire le fonctionnement du dispositif de la figure 1 en supposant que des signaux d'entrée E sont appliqués pendant la phase PH0 à la première matrice 1. Les signaux PH0 et PH1 sont les deux phases successives d'un signal d'une horloge non représentée.

Pendant la phase PH0, les lignes de sortie S de la deuxième matrice 2 sont préchargées à une tension déterminée au moyen du circuit de précharge 5. Pendant cette même phase, les lignes d'entrée de la seconde matrice 2 reçoivent une tension de forçage par le circuit 6. Par ailleurs les moyens d'isolement 9 isolent la sortie des moyens de mémorisation 7 du circuit 6. De plus pendant la phase PH0 les premiers moyens d'isolement 8 mettent en communication les lignes de sortie ME de la première matrice 1 avec les entrées des moyens de mémorisation 7. Enfin les circuits de précharge 3 et 4 sont inhibés.

Il en résulte que durant cette phase PH0 la matrice 1, supposée préchargée initialement, est active. Les tensions présentes sur les lignes de sortie ME de cette matrice qui représentent les valeurs logiques des monômes (mintermes ou maxtermes) intervenant dans la définition des fonctions logiques à réaliser, sont transmis aux moyens de mémorisation 7 dont les sorties restent isolées.

Au cours de la phase suivante PH1, ce sont les circuits de précharge 3, 4 de la première matrice qui sont rendus actifs alors que le premier moyen d'isolement 8 isole les moyens de mémorisation 7 de la première matrice. D'autre part les circuits de précharge 5 et 6 de la seconde matrice 2 sont inactifs. Enfin les seconds moyens d'isolement 9 permettent le transfert des signaux enmagasinés pendant la phase précédente dans les moyens de mémorisation 7 vers les entrées de la seconde matrice 2. Lorsque les circuits de la seconde matrice sont stabilisés, des signaux représentatifs des fonctions logiques réalisées par le réseau logique sont présents sur les lignes de sortie S.

Au début de la phase suivante PH0, la première matrice 1 est bien préchargée et peut donc entamer une nouvelle phase fonctionnelle comme décrit précédemment.

Ainsi le réseau logique représenté à la figure 1 permet bien un fonctionnement en deux phases d'horloge seulement. Ceci est rendu possible par la présence des moyens de mémorisation 7 et des premiers et seconds moyens d'isolement 8 et 9 qui autorisent que la phase fonctionnelle de l'une des matrices coïncide avec la phase de précharge de l'autre matrice et réciproquement.

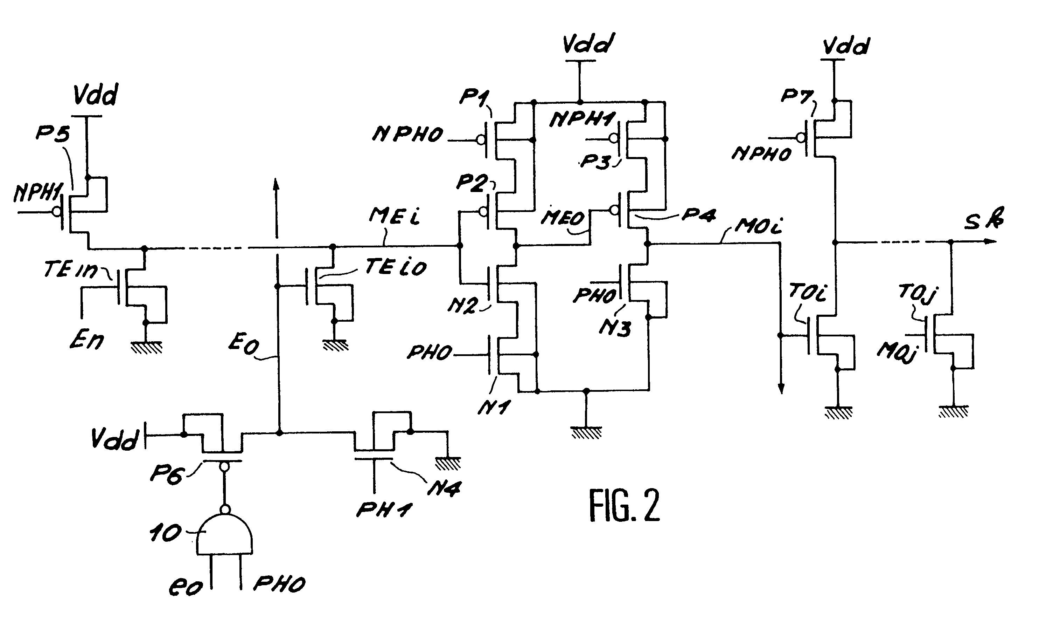

En nous référant maintenant à la figure 2, nous allons décrire un mode de réalisation particulier du réseau logique selon l'invention. Selon cet exemple de réalisation, les deux matrices 1 et 2 sont constituées par des réseaux de transistors à effet de champs à canal n du type NMOS connectés de façon à former des portes logiques NI. Pour des raisons de clarté, il n'a été représenté qu'une seule porte logique par matrice.

Par convention, les transistors à effet de champs à canal p sont représentés avec un petit rond dessiné sur leur grille.

L'une des portes logiques NI de la première matrice est constituée par des transistors TEi0...TEin ayant leur source reliée à la masse et leur drain relié à l'une des lignes de sortie MEi de la première matrice. Les grilles de ces transistors reçoivent respectivement les signaux E0...En issus d'un circuit associé. Egalement pour des raisons de clarté, seul le circuit N4, P6 associé au premier transistor TEi0 est représenté sur la figure 2. Ce circuit comprend un premier transistor à effet de champs à canal p P6 dont la source est reliée à une tension d'alimentation positive Vdd et dont le drain est relié au drain d'un transistor à effet de champs à canal n N4 et à la grille du transistor TE0. La source du transistor N4 est reliée à la masse. Ce dernier transistor N4 reçoit sur sa grille le signal PH1 définissant la seconde phase d'horloge. La grille du transistor P6 est reliée à la sortie d'une porte NON-ET 10 à deux entrées, la première de ses entrées recevant le signal PH0 définissant la première phase d'horloge, la seconde entrée recevant la variable logique e0. Il est à noter que le signal e0 représente une variable logique d'entrée ou son complément, selon la fonction logique réalisée.

Le circuit de précharge de la ligne de sortie MEi est simplement constitué par un transistor à effet de champs à canal p P5 dont la source est reliée à une tension d'alimentation positive Vdd et dont le drain est relié à la ligne MEi. Le signal complémentaire NPH1 du signal PH1 est appliqué à la grille du transistor P5.

Les transistors à effet de champs à canal n TOi...TOj constituent une porte logique NI appartenant à la seconde matrice 2. La source de chacun de ces transistors est reliée à la masse et leur drain est relié à l'une des lignes de sortie Sk de la seconde matrice 2. Les grilles de ces transistors reçoivent respectivement les signaux MOi...MOj en provenance d'un circuit associé. Pour des raisons de clarté, seul le circuit P1 à P4, N1 à N3 associé au transistor TOi a été représenté sur la figure 2.

Le circuit de précharge de la ligne de sortie Sk de la seconde matrice est réalisé au moyen d'un transistor à effet de champs à canal p P7 dont la source est reliée à une tension d'alimentation positive Vdd et dont le drain est relié à la ligne de sortie S. Le signal complémentaire NPH0 du signal PH0 est appliqué à la grille de ce transistor.

La ligne de sortie MEi de la première matrice est reliée à la grille d'un transistor à effet de champs à canal n N2 et à la grille d'un transistor à canal p P2 dont les drains sont reliés ensemble. La source du transistor P2 est reliée au drain d'un autre transistor à canal p P1 dont la source est reliée à un tension d'alimentation positive Vdd. La grille du transistor P1 reçoit le signal supplémentaire NPH0 du signal PH0. La source du transistor N2 est reliée au drain d'un transistor à canal n N1 dont la source est reliée à la masse. La grille du transistor N1 reçoit le signal PH0. Le montage constitué par les transistors P1, P2, N2, N1 constitue un inverseur à trois états.

Le signal MEO présent sur les drains des transistors N2 et P2 est appliqué sur la grille d'un autre transistor à canal p P4 dont la source est reliée au drain d'un transistor à canal p P3 ayant sa source reliée à une tension d'alimentation positive Vdd. Le signal complémentaire NPH1 du signal PH1 est appliqué sur la grille du transistor P3. Le drain du transistor P4 est relié au drain d'un autre transistor à canal n N3 dont la source est reliée à la masse. Le signal de phase PH0 est appliqué sur la grille du transistor N3.

Le signal MOi présent sur les drains des transistors N3 et P4 est appliqué sur la grille du transistor TOi associé. Selon les fonctions logiques que l'on veut réaliser au moyen de ce réseau logique, le signal MOi peut être appliqué également à la grille d'un autre transistor faisant partie d'une autre porte logique NI non représentée de la seconde matrice.

Avant de décrire le fonctionnement du circuit de la figure 2, il convient d'exposer la correspondance entre les éléments du circuit de cette figure avec les éléments représentés sur la figure 1.

Le circuit de précharge 5 des lignes de sortie de la seconde matrice 2 est constitué par autant de transistors P7 que la seconde matrice a de sorties. De même le circuit de précharge 3 des lignes de sortie de la première matrice 1 est constitué par autant de transistors P5 que la première matrice a de sorties.

Le circuit de forçage 4 des lignes d'entrée de la première matrice est constitué par autant de transistors N4 que la première matrice a d'entrées. De même le circuit de forçage 6 des lignes d'entrée de la seconde matrice 2 est constitué par autant de transistors N3 que cette matrice a d'entrées.

Les premiers moyens d'isolement 8 sont constitués par autant d'inverseurs à trois états P1, P2, N2, N1 que la première matrice a de lignes de sortie.

Les seconds moyens d'isolement 8 sont constitués par les transistors P3 correspondants.

Enfin une cellule de mémorisation associée à une ligne de sortie de la première matrice est réalisée par la capacité de structure du transistor P4.

Il est à noter que l'inverseur à trois états P1, P2, N2, N1 et le montage constitué par les transistors N3, P3, P4, ont aussi une fonction d'amplification.

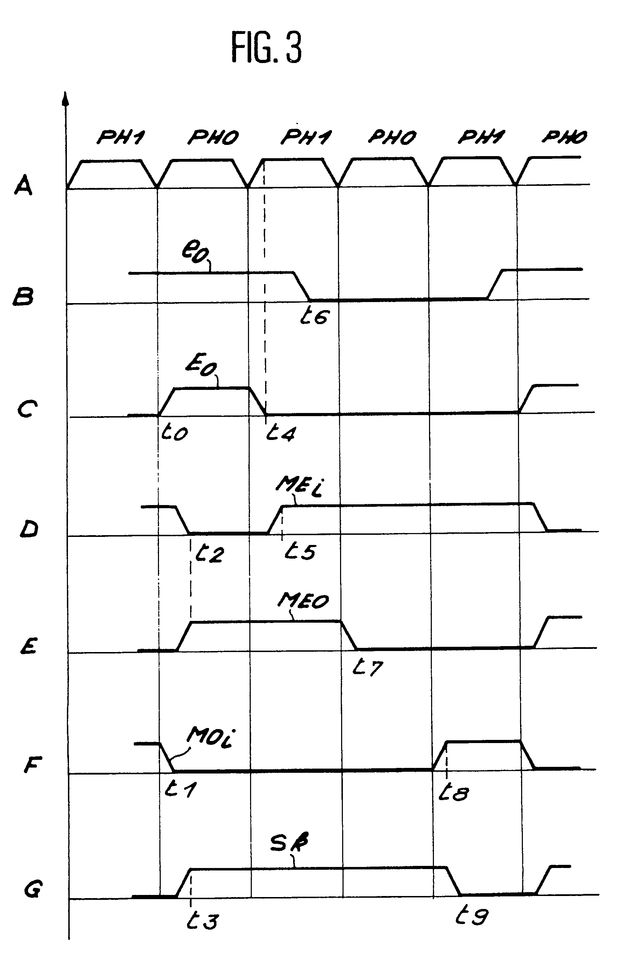

Pour décrire maintenant le fonctionnement du circuit de la figure 2, il convient de se reporter aux chronogrammes représentés sur la figure 3.

Le chronogramme A représente les signaux PH0 et PH1 définissant les deux phases d'horloge.

Le chronogramme B représente le signal e0 appliqué à l'entrée de la porte 10.

Le chronogramme C représente la tension E0 présente sur la grille du transistor TEi0.

Le chronogramme D représente la tension présente sur la ligne de sortie MEi de la première matrice.

Le chronogramme E représente la tension mémorisée MEO présente sur la grille du transistor P4.

Le chronogramme F représente la tension MOi apparaissant sur les drains des transistors N3 et P4.

Le chronogramme G représente enfin le signal de sortie Sk de la porte logique NI de la seconde matrice représentée sur la figure 2.

Pour expliquer le fonctionnement du circuit, il est supposé que le signal d'entrée e0 a initialement la valeur 1 logique jusqu'à l'instant t6 puis passe à la valeur 0 logique. Cet exemple permet d'illustrer le fonctionnement du circuit dans un cas particulier qui peut être généralisé très facilement quel que soit le nombre d'entrées et de sorties du réseau logique et quelles que soient les valeurs logiques prises par les variables d'entrée.

Les signaux PH0 et PH1 du chronogramme A définissent les deux phases de fonctionnement du dispositif. Selon le chronogramme A, les phases PH0 et PH1 ont été supposées adjacentes mais le même fonctionnement pourrait être obtenu en utilisant deux signaux de phase présentant un temps mort entre ces deux phases. La seule condition est que les phases PH0 et PH1 ne se recouvrent pas.

A l'instant t0, nous sommes au début de la première phase PH0 et la tension de sortie de la porte NON-ET 10 prend la valeur 0 logique. Il en résulte que le transistor P6 est passant. D'autre part le signal PH1 ayant la valeur 0 logique, le transistor N4 est bloqué. Il en résulte que le signal E0 appliqué à la grille du transistor TEi0 prend la valeur 1 logique rendant ainsi ce transistor conducteur. Par ailleurs le signal NPH1 qui est le complément du signal PH1 a la valeur 1 logique rendant le transistor P5 bloqué. La ligne de sortie MEi se décharge donc par l'intermédiaire du chemin drain-source du transistor TEi0.

Le signal NPH0 complément du signal PH0 a la valeur 0 logique rendant ainsi conducteur le transistor P1. De même le signal PH0 appliqué au transistor N1 rend celui-ci conducteur. Il en résulte que l'inverseur à trois états P1, P2, N2, N1 fonctionne en inverseur. Ainsi à l'instant t2 correspondant à la fin de la décharge de la ligne MEi, la tension MEO appliquée à la grille du transistor P4 prend la valeur 1 logique.

Par ailleurs le signal NPH1 appliqué à la grille du transistor P3 est nul, ce qui rend ce transistor bloqué. Enfin le signal PH0 appliqué à la grille du transistor N3 rend ce dernier conducteur. Il en résulte que, quelle que soit la valeur de la tension ME0, la tension MOi appliquée au transistor TOi devient nulle, amenant ainsi ce transistor à l'état bloqué. Enfin le signal NPH0 ayant une tension nulle, le transistor T7 est rendu conducteur. La ligne de sortie Sk est ainsi préchargée à la tension Vdd. Cet état apparaît à partir de l'instant t3 représenté sur le chronogramme G.

Après l'établissement de la phase suivante PH1 à l'instant t4, la tension de sortie de la porte 10 prend la valeur 1 logique de même que la tension appliquée à la grille du transistor N4. Ceci entraîne le passage à 0 du signal E0 bloquant ainsi le transistor TEi0. Comme la tension appliquée à la grille du transistor P5 est nulle, ce transistor est conducteur. Il en résulte que la ligne MEi se charge à la tension d'alimentation Vdd, ce qui est réalisé à l'instant t5 du chronogramme D.

Par ailleurs les transistors P1 et N1 sont bloqués, ce qui empêche tout changement de tension du signal MEO. Il s'agit là de l'effet de mémorisation recherché. Par ailleurs le transistor P3 est conducteur et le transistor N3 est bloqué. Mais comme la tension de grille MEO du transistor P4 a une valeur positive, ce transistor reste bloqué, maintenant à la valeur 0 la tension du signal MOi. Il en résulte que le transistor TOi reste bloqué et ne modifie donc pas la tension de sortie Sk, qui garde la valeur 1 logique si aucun des autres transistors TOj n'a déchargé la ligne de sortie Sk.

Lors de la phase PHO suivante, les transistors N3 et P7 deviennent conducteurs à partir de l'instant t7 et le transistor P3 est bloqué, permettant ainsi la précharge de la ligne Sk.

D'autre part le transistor P5 est bloqué ce qui autorise un changement de tension de la ligne MEi. Comme nous avons supposé que la nouvelle valeur logique prise à l'instant t6 par le signal d'entrée e0 était 0, il en résulte que le transistor P6 est conducteur, le transistor N4 étant bloqué. Il s'ensuit que la tension E0 garde la valeur 0 maintenant ainsi le transistor TEi0 à l'état bloqué.

Si aucun autre transistor TEin n'est conducteur, la ligne MEi garde une tension positive, ce qui maintient à 0 la tension MEO de la grille du transistor P4.

Lors de la phase PH1 suivante, dès l'instant t8, les transistors P1, N1, N3 son à nouveau bloqués et le transistor P3 est conducteur. Comme le signal ME0 est à 0, le transistor P4 est rendu conducteur ce qui fait passer à la valeur 1 logique le signal MOi à l'instant t8. Il en résulte que le transistor TOi est rendu conducteur, ce qui produit la décharge à l'instant t9 de la ligne de sortie Sk.

Le mode de réalisation de l'invention et son fonctionnement décrits précédemment démontrent que le but de l'invention est parfaitement atteint au moyen d'un nombre de composants supplémentaires minimal. Il est clair toutefois que le dispositif selon l'invention trouve surtout son intérêt dans le cas où le nombre de monômes (mintermes ou maxtermes) c'est-à-dire le nombre de lignes de sortie de la première matrice est relativement limité.

Il convient de noter qu'au début de la phase de précharge de la première matrice c'est-à-dire au début de la phase PH1, il existe le risque que les transistors P5 et TEi0 soient simultanément conducteurs créant ainsi une situation de conduction. Cette conduction peut facilement être réduite en prenant la précaution de dimensionner les transistors N4 et P5 de sorte que le transistor N4 ait un temps de commutation plus court que celui du transistor P5. Pour la même raison, il conviendra de dimensionner les transistors N3 et P7 de sorte que le transistor N3 soit plus rapide que le transistor P7.

**Revendications**

1. Réseau logique constitué d'une première matrice (1) de portes logiques dont les signaux de sortie (ME) sont transmis aux entrées (MO) d'une seconde matrice (2) constituée d'une ou plusieurs portes logiques, chaque porte logique desdites matrices (1, 2) étant des portes NI dynamiques réalisées au moyen de transistors à effet de champ à canal n (TEi0, TEin, TOi, TOj), une phase de précharge servant à charger à une tension déterminée (Vdd) les lignes de sortie (MEi, S) desdites portes logiques par des moyens de précharge (3, 4, 5, 6) rendus actifs par un signal de commande de précharge, ledit réseau comprenant des moyens de mémorisation (7) dont les entrées sont reliées aux sorties de la première matrice (1) par l'intermédiaire de premiers moyens d'isolement commandés (8), les sorties (MEO) desdits moyens de mémorisation étant reliés aux entrées de la seconde matrice (2) par l'intermédiaire de seconds moyens d'isolement commandés (9), lesdits premiers moyens d'isolement (8) étant commandés pour autoriser le transfert des signaux issus de la première matrice (1) vers lesdits moyens de mémorisation (7) pendant la phase de précharge (PHO) de la seconde matrice (2), lesdits seconds moyens d'isolement (9) étant commandés pour autoriser le transfert des données contenues dans lesdits moyens de mémorisation (7) vers la seconde matrice (2) pendant la phase de précharge (PH1) de la première matrice (1), ledit réseau étant caractérisé en ce que lesdits moyens de précharge desdites portes NI comprennent des moyens (N4, N3) pour appliquer sur leurs entrées une tension nulle, lesdits moyens (N4, N3) étant activés pendant la phase de précharge (PH1, PH0) desdites portes logiques à partir d'un signal d'horloge directement dérivé de celui servant à la précharge.

2. Réseau logique selon la revendication précédente caractérisé en ce que lesdits moyens d'isolement (8, 9) comportent des moyens (P2, N2, P3, P4) pour amplifier leurs signaux d'entrée.

3. Réseau logique selon la revendication précédente caractérisé en ce que lesdits moyens de précharge (3, 4, 5, 6) comprennent pour chaque ligne de sortie desdites matrices un transistor de précharge du type à effet de champs à canal p (P5, P7) dont la source est reliée à une source de tension positive (Vdd), dont le drain est relié à la ligne de sortie associée, lesdits transistors affectés respectivement à la première et à la seconde matrice (1, 2) étant rendus conducteurs pendant la phase de précharge, respectivement, de la première et de la seconde matrice.

4. Réseau logique selon la revendication précédente caractérisé en ce que lesdits moyens de précharge (3, 4, 5, 6) comprennent pour chaque ligne d'entrée desdites matrices un transistor d'inhibition du type à effet de champs à canal n (N4, N3) dont la source est reliée à la masse, dont le drain est relié à la ligne d'entrée associée, lesdits transistors affectés respectivement à la première et à la seconde matrice (1, 2) étant rendus conducteurs pendant la phase de précharge, respectivement, de la première et de la seconde matrice.

5. Réseau logique selon la revendication précédente caractérisé en ce que la phase de précharge d'une matrice est commandée par un signal d'horloge constitué par deux phases positives (PH0, PH1) successives, lesdites première et seconde phases dudit signal d'horloge étant appliquées respectivement aux grilles des transistors d'inhibition (N4, N3) de la seconde et de la première matrice, les signaux complémentaires (NPH0, NPH1) desdites phases (PH0, PH1) étant appliqués, respectivement aux grilles des transistors de précharge desdites seconde et première matrices.

6. Réseau logique selon la revendication précédente caractérisé en ce que lesdits premier et second moyens d'isolement (8, 9) et lesdits moyens de mémorisation (7) reliant une ligne de sortie (MEi) de la première matrice (1) à une ligne d'entrée (MOi) de la seconde matrice (2) sont réalisés par un circuit unique constitué par un inverseur à trois états (P1, P2, N1, N2) rendu actif par la première phase d'horloge (PH0), dont la sortie (ME0) est reliée à la grille d'un premier transistor (P4) à effet de champs de type p, dont la source est reliée au drain d'un second transistor (P3) à effet de champs de type p dont la source est reliée à ladite source de tension positive (Vdd), le drain dudit premier transistor (P4) étant relié à ladite ligne d'entrée (MOi) de la seconde matrice (2), la grille dudit second transistor (P3) recevant le signal complémentaire (NPH1) de la seconde phase d'horloge (PH1), l'effet de mémorisation dudit circuit étant obtenu par la capacité de structure dudit premier transistor (P4).

7. Réseau logique selon la revendication précédente caractérisé en ce que chaque ligne d'entrée (Eo) de la première matrice (1) est reliée au drain d'un transistor (P6) à effet de champs de type p dont la source est reliée à ladite source de tension positive (Vdd), dont la grille est reliée à la sortie d'un circuit NON-ET (10) dont une entrée reçoit la première phase d'horloge (PH0) et dont une autre entrée reçoit le signal d'entrée (20) associé à ladite ligne d'entrée (Eo).

8. Réseau logique selon l'une des revendications 4 à 7 caractérisé en ce que lesdits transistors d'inhibitions (N4, N3) des matrices sont dimensionnés de façon à être plus rapides que lesdits transistors de précharges (P5, P7) desdites matrices.

**Patentansprüche**

1. Logik-Netzwerk, das eine erste Matrix (1) von Logik-Gattern aufweist, deren Ausgangssignale (ME) an die Eingänge (M0) einer zweiten Matrix (2) übertragen werden, die ein oder mehrere Logik-Gatter aufweist, wobei jedes Logik-Gatter der Matrizen (1, 2) ein dynamisches NOR-Gatter ist, das mittels n- Kanal-Feldeffekttransistoren (TEiO, TEin, T0i, T0j) verwirklicht wird, wobei eine Vorladungsphase der Aufladung der Ausgangsleitungen (MEi, S) der Logik-Gatter auf eine bestimmte Spannung (Vdd) durch mittels eines Vorladungs- Steuersignals aktivierte Vorladungsmittel (3, 4, 5, 6) dient, wobei das Netzwerk Speichermittel (7) aufweist, deren Eingänge über dazwischengeschaltete erste gesteuerte Isolationsmittel (8) mit den Ausgängen der ersten Matrix (1) verbunden sind, wobei die Ausgänge (ME0) der Speichermittel über dazwischengeschaltete zweite gesteuerte Isolationsmittel (9) mit den Eingängen der zweiten Matrix (2) verbunden sind, wobei die ersten Isolationsmittel (8) so gesteuert werden, daß sie die Übertragung der von der ersten Matrix (1) an die Speichermittel (7) ausgegebenen Signale während der Vorladungsphase (PH0) der zweiten Matrix (2) zuzulassen, wobei die zweiten Isolationsmittel (9) so gesteuert werden, daß sie die Übertragung der in den Speichermitteln (7) enthaltenen Daten an die zweite Matrix (2) während der Vorladungsphase (PH1) der ersten Matrix (1) zulassen, wobei das Netzwerk dadurch gekennzeichnet ist, daß die Vorladungsmittel der NOR- Gatter Mittel (N4, N3) aufweisen, um an ihre Eingänge eine Nullspannung anzulegen, wobei die Mittel (N4, N3) während der Vorladungsphase (PH1, PH0) der Logik-Gatter anhand eines Taktsignals, das direkt aus dem der Vorladung dienenden Signal abgeleitet wird, aktiviert werden.

2. Logik-Netzwerk gemäß dem vorangehenden Anspruch, dadurch gekennzeichnet, daß die Isolationsmittel (8, 9) Mittel (P2, N2, P3, P4) zum Verstärken ihrer Eingangssignale aufweisen.

3. Logik-Netzwerk gemäß dem vorangehenden Anspruch, dadurch gekennzeichnet, daß die Vorladungsmittel (3, 4, 5, 6) für jede Ausgangsleitung der Matrizen einen Vorladungtransistor vom Typ eines p-Kanal- Feldeffekttransistors (P5, P7) aufweisen, dessen Source mit einer positiven Spannungsquelle (Vdd) verbunden ist und dessen Drain mit der zugehörigen Ausgangsleitung verbunden ist, wobei die für die erste bzw. für die zweite Matrix (1, 2) eingesetzten Transistoren während der Vorladungsphase der ersten bzw. der zweiten Matrix in den leitenden Zustand versetzt werden.

4. Logik-Netzwerk gemäß dem vorangehenden Anspruch, dadurch gekennzeichnet, daß die Vorladungsmittel (3, 4, 5, 6) für jede Eingangsleitung der Matrizen einen Sperrtransistor vom Typ eines n-Kanal-Feldeffekttransistors (N4, N3) aufweisen, dessen Source mit Masse verbunden ist, dessen Drain mit der zugehörigen Eingangsleitung verbunden ist, wobei die für die erste bzw. für die zweite Matrix (1, 2) eingesetzten Transistoren während der Vorladungsphase der ersten bzw. der zweiten Matrix in den leitenden Zustand versetzt werden.

5. Logik-Netzwerk gemäß dem vorangehenden Anspruch, dadurch gekennzeichnet, daß die Vorladungsphase einer Matrix durch ein Taktsignal gesteuert wird, das durch zwei aufeinanderfolgende positive Phasen (PH0, PH1) gebildet wird, wobei die erste und die zweite Phase des Taktsignals an die Gates der Sperrtransistoren (N4, N3) der zweiten bzw. der ersten Matrix angelegt werden und wobei die komplementären Signale (NPH0, NPH1) der Phasen (PH0, PH1) an die Gates der Vorladungstransistoren der zweiten bzw. der ersten Matrix angelegt werden.

6. Logik-Netzwerk gemäß dem vorangehenden Anspruch, dadurch gekennzeichnet, daß die ersten und die zweiten Isolationsmittel (8, 9) und die Speichermittel (7), die eine Ausgangsleitung (MEi) der ersten Matrix (1) mit einer Eingangsleitung (MOi) der zweiten Matrix (2) verbinden, durch eine einzige Schaltung verwirklicht werden, die durch einen Inverter mit drei Zuständen (P1, P2, N1, N2) gebildet wird, der durch die erste Taktphase (PH0) aktiviert wird, dessen Ausgang (ME0) mit dem Gate eines ersten p-Kanal-Feldeffekttransistors (P4) verbunden ist, dessen Source mit dem Drain eines zweiten p-Kanal-Feldeffekttransistors (P3) verbunden ist, dessen Source mit der positiven Spannungsquelle (Vdd) verbunden ist, wobei der Drain des ersten Transistors (P4) mit der Eingangsleitung (MOi) der zweiten Matrix (2) verbunden ist, wobei das Gate des zweiten Transistors (P3) das zu der zweiten Taktphase (PH1) komplementäre Signal (NPH1) empfängt und wobei die Speicherwirkung der Schaltung durch die Kapazität der Struktur des ersten Transistors (P4) erreicht wird.

7. Logik-Netzwerk gemäß dem vorangehenden Anspruch, dadurch gekennzeichnet, daß die Eingangsleitung (Eo) der ersten Matrix (1) mit dem Drain eines p-Kanal-Feldeffekttransistors (P6) verbunden ist, dessen Source mit der positiven Spannungsquelle (Vdd) verbunden ist, dessen Gate mit dem Ausgang einer NAND-Schaltung (10) verbunden ist, deren Eingang die erste Taktphase (PH0) empfängt und deren anderer Eingang das der Eingangsleitung (Eo) zugehörige Eingangssignal (20) empfängt.

8. Logik-Netzwerk gemäß einem der Ansprüche 4 bis 7, dadurch gekennzeichnet, daß die Sperrtransistoren (N4, N3) der Matrizen so dimensioniert sind, daß sie schneller als die Vorladungstransistoren (P5, P7) der Matrizen sind.

## Claims

1. Logic network comprising a first matrix (1) of logic gates the output signals (ME) of which are transmitted to the inputs (MO) of a second matrix (2) comprising one or more logic gates, each logic gate of said matrices (1, 2) being dynamic NOR gates provided by means of n channel field effect transistors (TEio, TEin, TOi, TOj), a precharging phase, serving to charge the output lines (MEi, S) of said logic gates to a predetermined voltage (Vdd) by precharging means (3, 4, 5, 6) made active by a precharging control signal, the said network comprising memorising means (7) the inputs of which are connected to the outputs of the first matrix (1) by way of first controlled isolating means (8), the outputs (MEO) of said memorising means being connected to the inputs of the second matrix (2) by way of second controlled isolating means (9), said first isolating means (8) being controlled for authorising the transfer of the signals emitted by the first matrix (1) to said memorising means (7) during the precharging phase (PHO) of the second matrix (2), said second isolating means (9) being controlled for authorising the transfer of the data contained in said memorising means (7) to the second matrix (2) during the precharging phase (PH1) of the first matrix (1), the said network being characterised in that the said precharging means of the said NOR gates comprises means (N4, N3) for applying a null voltage on their inputs, the said means (N4, N3) being activated during the precharging phase (PH1, PH0) of the said logic gates, from a clock signal directly derived from that serving for the precharge.

2. Logic network according to the preceding claim, characterised in that said isolating means (8, 9) include means (P2, N2, P3, P4) for amplifying their input signals.

3. Logic network according to the preceding claim, characterised in that said precharging means (3, 4, 5, 6) comprise for each output line of said matrices, one precharging transistor of the p channel field effect type (P5, P7), the source of which is connected to a source of positive voltage (Vdd), the drain of which is connected to the associated output line, the said transistors assigned respectively to the first and the second matrix (1, 2) being made conductive during the precharging phase of the first and second matrix, respectively.

4. Logic network according to the preceding claim, characterised in that said precharging means (3, 4, 5, 6) include for each input line of said matrices an inhibition transistor of the n channel field effect type (N4, N3), the source of which is connected to ground, the drain of which is connected to the associated input line, the said transistors assigned respectively to the first and second matrix (1, 2) being made conductive during the precharging phase of the first and second matrix, respectively.

5. Logic network according to the preceding claim, characterised in that the precharging phase of one matrix is controlled by a clock signal comprising two successive positive phases (PH0, PH1), said first and second phases of said clock signal being applied respectively to the gates of inhibition transistors (N4, N3) of the second and of the first matrix, the complementary signals (NPH0, NPH1) of said phases (PH0, PH1) being applied respectively to the gates of the precharging transistors of said second and first matrices.

6. Logic network according to the preceding claim, characterised in that the said first and second isolating means (8, 9) and said memorising means (7) connecting an output line (MEi) of the first matrix (1) to an input line (MOi) of the second matrix (2) are attained by a single circuit comprising a three-state inverter (P1, P2, N1, N2) made active by the first clock phase (PH0), the output (MEO) of which is connected to the gate of a first p channel field effect transistor (P4), the source of which is connected to the drain of a second p channel field effect transistor (P3), the source of which is connected to said source of positive voltage (Vdd), the drain of said first transistor (P4) being connected to said input line (MOi) of the second matrix (2), the gate of said second transistor (P3) receiving the complementary signal (NPH1) of the second clock phase (PH1), the effect of memorisation of said circuit being obtained via the structural capacity of said first transistor (P4).

7. Logic network according to the preceding claim, characterised in that each input line ($E_o$) of the first matrix (1) is connected to the drain of a p channel field effect transistor (P6), the source of which is connected to said source of positive voltage (Vdd), the gate of which is connected to the output of a NAND circuit (10), one input of which receives the first clock phase (PHO) and another input of which receives the input signal (20) associated with said input line (EO).

8. Logic network according to one of claims 4 to 7, characterised in that said inhibition transistors (N4, N3) of the matrices are dimensioned such as to be faster than said precharging transistors (P5, P7) of said matrices.

EP 0 282 370 B1

# FIG. 1

FIG. 2

EP 0 282 370 B1

# FIG. 3